# EUROPEAN PATENT APPLICATION

(11) **EP 3 426 010 A1**
(43) Date of publication of application: **09.01.2019**
(21) Application number: 16896636.4
(22) Date of filing: 12.12.2016
(51) Int. Cl.: H05K 1/18

(54) **SUBSTRATE AND MOBILE TERMINAL**

(30) Priority: 31.03.2016 CN 201610200436
(71) Applicant: Huawei Technologies Co., Ltd., Longgang District Shenzhen, Guangdong 518129 (CN)
(72) Inventor: BAO, Kuanming, Shenzhen Guangdong 518129 (CN)
(74) Representative: Pfenning, Meinig & Partner mbB
(86) International application number: PCT/CN2016/109540
(87) International publication number: WO 2017/166868

(57) **Abstract**

The present invention relates to the field of electronic technologies, and discloses a base board and a mobile terminal. The base board includes an electrical pattern and multiple components, the base board further includes a resin layer and a thin resin layer, the component is embedded in the resin layer, and an end face of a foot is flush to a surface of the resin layer; and the thin resin layer is attached to one exposed side of a foot of a component in the resin layer, a through hole corresponding to each foot is disposed in the thin resin layer, the circuit pattern is attached to one side that is of the thin resin layer and that is opposite to the resin layer, and the circuit pattern is connected to a pad that is electrically connected to a foot and that stretches into each through hole. In the foregoing technical solution, all pad surfaces of components in a same direction are located in a same plane, and thin resin is pressed, thereby meeting a same depth requirement of a component pad to a copper layer, reducing a requirement for a pad size and a pad spacing, and facilitating processing. Further, a connection effect of the circuit pattern is improved, and problems of properness of an overall module layout and product miniaturization and thinness are resolved.

## Description

This application claims priority to Chinese Patent Application No.201610200436.4, filed with the Chinese Patent Office on March 31, 2016 and entitled "BASE BOARD AND MOBILE TERMINAL", which is incorporated herein by reference in its entirety.

### TECHNICAL FIELD

The present invention relates to the field of electronic technologies, and in particular, to a base board and a mobile terminal.

### BACKGROUND

Currently, an ECP technology is mainly used in the industry to enhance product performance, implement higher integration, and meet a requirement for a thinner and smaller product. An embedded base board belongs to a new encapsulation technology in which a component is embedded in a base board/PCB according to a processing technology of the base board/the PCB and a component assembly feature. The embedded base board improves product integration, reduces an overall size of a module, and further improves product reliability and electric heating performance.

However, in the prior art, components are embedded in a same resin layer in an embedded common ECP processing process. When multiple components are applied to an embedded base board, because heights of the multiple components are different, an embedded structure in the prior art cannot ensure a same height of a component pad to a copper layer of a surface of the base board, and consequently, when the components are being connected, depths of holes that need to be disposed are different, and processing depths of all holes are different in a processing process. This greatly affects working efficiency of the base board during processing. In addition, because embedded depths of the components are different, pad sizes are different when a component is connected to a circuit pattern, and when the circuit pattern is being formed, this affects an effect of connecting the component to the circuit pattern.

### SUMMARY

The present invention provides a base board and a mobile terminal, so as to improve an effect of connecting a component on a base board to a circuit pattern.

To resolve the foregoing technical problem, the present invention provides a base board, where the base board includes an electrical pattern and multiple components, the base board further includes a resin layer and a thin resin layer, the multiple components are embedded in the resin layer, and an end face that is of a foot of each component and that is used to connect the circuit pattern is exposed out of the resin layer and is flush to a surface of the resin layer; and the thin resin layer is attached to one exposed side of a foot of a component in the resin layer, a through hole corresponding to each foot is disposed in the thin resin layer, the circuit pattern is attached to one side that is of the thin resin layer and that is opposite to the resin layer, and the circuit pattern is connected to a pad that is electrically connected to a foot and that stretches into each through hole.

In the foregoing technical solution, the multiple components are embedded in the resin layer, and during embedment, feet of the multiple components are flush to the surface of the resin layer. Therefore, in a production process of the base board, when the thin resin layer is punctured to expose the feet of the components, puncturing depths are the same, thereby implementing puncturing controllability and facilitating processing. In addition, the feet of the multiple components are disposed on a same surface, thereby improving pad possibility, and further improving a connection effect of the circuit pattern.

In the foregoing specific setting, the base board further includes a protective layer that covers the thin resin layer, multiple window structures are disposed at the protective layer, and the multiple window structures are in a one-to-one correspondence with external ports of the circuit pattern. The disposed protective layer wraps the base board, thereby avoiding copper oxidation caused because of cable exposure of the circuit pattern on the base board, and improving a use effect of the entire base board.

In a specific case, the circuit pattern on the base board is distributed in the two thin resin layers, and two layers of the circuit pattern are connected by using a plated through hole that penetrates through the resin layer and the thin resin layer. A foot of each component in the multiple components faces one side that is of the circuit pattern and that is connected to the foot of each component. That is, the circuit pattern on the base board is disposed in two opposite surfaces of the base board in two layers, thereby improving distribution efficiency of the circuit pattern. When a component is being disposed, a foot of the component faces a connection point that is of the circuit pattern and that is correspondingly connected to the foot of the component, thereby simplifying a layout of the circuit pattern, shortening a cabling length, improving utilization of the base board, and further improving an overall effect of the base board.

A thickness of the thin resin layer is from 20 µm to 30 µm in the foregoing setting. Therefore, a puncturing depth and a pad footprint can be effectively controlled. The thickness of the thin resin layer is 20 µm in more specific setting.

The present invention further provides a mobile terminal. The mobile terminal includes a housing, a power supply module disposed within the housing, and a control module connected to the power supply module, and the power supply module and the control module each include the above base board.

In the foregoing technical solution, all pad surfaces of components in a same direction are located in a same plane, and thin resin is pressed, thereby meeting a same depth requirement of a component pad to a copper layer, reducing a requirement for a pad size and a pad spacing, and facilitating processing. Further, a connection effect of a circuit pattern is improved, problems of properness of an overall module layout and product miniaturization and thinness are resolved, thereby improving an effect of product miniaturization and thinness in electrical connection of the power supply module, the control module, and the like, and promoting processing and thinness development of the mobile terminal.

The mobile terminal may be different terminals, such as a mobile phone or a wearable communications device.

### BRIEF DESCRIPTION OF DRAWINGS

FIG. 1 is a schematic structural diagram of a base board according to an embodiment of the present invention;
FIG. 2 is a schematic structural diagram of another base board according to an embodiment of the present invention; and
FIG. 3a to FIG. 3m are a technological process diagram of a base board according to an embodiment of the present invention.

### Reference numerals:

1-Resin layer 2-Thin resin layer 21-Through hole 3-Component
31-Second component 32-First component 4-Circuit pattern
41-Copper clad layer 5-Protective layer 51-Window structure
6-Plated through hole 10-First adhesive film 11-Second adhesive film 20-Mold
201-Hollow-out structure

### DESCRIPTION OF EMBODIMENTS

To make the objectives, technical solutions, and advantages of the present invention clearer, the following further describes the present invention in detail with reference to the accompanying drawings. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

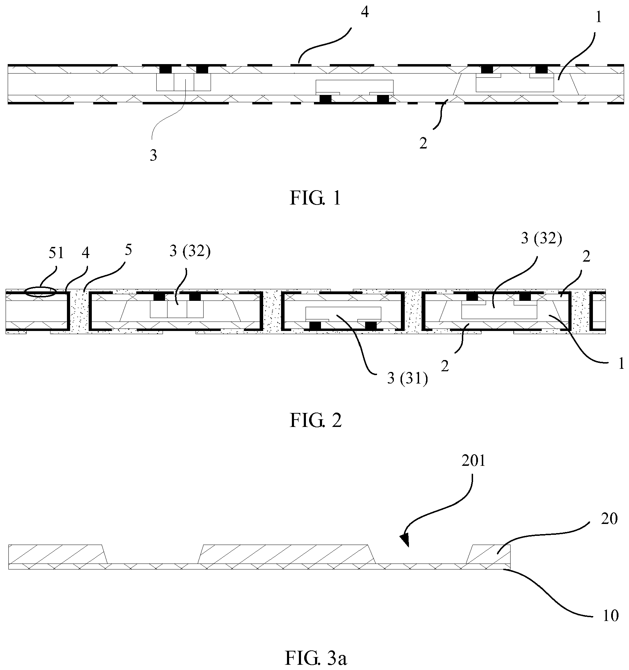

As shown in FIG. 1, FIG. 1 shows a schematic structural diagram of a base board according to an embodiment of the present invention.

To resolve the foregoing technical problem, this embodiment provides a base board. A circuit pattern 4 and multiple components 3 are disposed on the base board, and the base board further includes a resin layer 1 and a thin resin layer 2. The multiple components 3 are embedded in the resin layer 1, and an end face that is of a foot of each component 3 and that is used to connect the circuit pattern 4 is exposed out of the resin layer 1 and is flush to a surface of the resin layer 1; and the thin resin layer 2 is attached to one exposed side of a foot of a component 3 in the resin layer 1, a through hole corresponding to each foot is disposed in the thin resin layer 2, the circuit pattern 4 is attached to one side that is of the thin resin layer 2 and that is opposite to the resin layer 1, and the circuit pattern 4 is connected to a pad that is connected to a foot and that stretches into each through hole.

In the foregoing embodiment, pad surfaces of components in a same direction (that is, feet of components 3) are located in a same plane, and thin resin is pressed, thereby meeting a same depth requirement of a component pad to a copper layer. Therefore, in a production process of the base board, the thin resin layer 2 is punctured to expose the feet of the components 3, and puncturing depths are the same, thereby implementing puncturing controllability. In addition, a requirement for a pad size and a pad spacing is reduced. This facilitates processing, improves a connection effect of the circuit pattern 4, and resolves problems of properness of an overall module layout and product miniaturization and thinness.

To help understand a structure of the base board provided in this embodiment, the following describes the structure and a principle of the base board in detail with reference to the accompanying drawings.

As shown in FIG. 1 and FIG. 2, the base board provided in this embodiment includes three layers: two layers of thin resin layers 2 and a resin layer 1 clamped between the two layers of thin resin layers 2, and components 3 are embedded in the resin layer 1. In this embodiment, the components 3 include a first component 32 and a second component 31, first components 32 are components that face a same direction, and the second component 31 is a component 3 whose foot faces a direction opposite to that of a foot of the first component 32, that is, the foot of the first component 32 and the foot of the second component 31 are oppositely disposed.

Continuing to refer to FIG. 2, this embodiment provides multiple first components 32 and multiple second components 31, and a quantity of first components 32 and a quantity of second components 31 may be selected to an actual function of the base board. As shown in FIG. 2, in specific setting, a circuit pattern 4 on the base board is distributed in the two thin resin layers 2, and two layers of the circuit pattern 4 are connected by using a plated through hole 6 that penetrates through the resin layer 1 and the thin resin layer 2. A foot of each component 3 in the multiple components 3 faces one side that is of the circuit pattern 4 and that is connected to the foot of each component 3. Specifically, the first component 32 and the second component 31 are embedded in the resin layer 1, and end faces of the foot of the first component 32 and the foot of the second component 31 are flush to a surface of the resin layer 1, and the surface is a surface that is attached to the thin resin layer 2. A through hole 21 corresponding to the foot of the first component 32 and the foot of the second component 31 is disposed on the thin resin layer 2. According to the through hole 21 disposed on the thin resin layer 2, the foot of the first component 32 and the foot of the second component 31 are exposed and are connected to the circuit pattern 4. In addition, the two layers of the circuit pattern 4 are connected by using the plated through hole 6 that penetrates through the two layers of thin resin layers 2 and the resin layer 1 to form an entire circuit pattern 4.

In the foregoing setting, a path of the circuit pattern 4 on the base board is shorter, and a layout of the circuit pattern 4 is proper. Therefore, performance of the circuit pattern 4 is improved, and an area of the circuit pattern 4 can be effectively reduced. In comparison with a base board in the prior art, a common ECP (Electronic Circuit Protector, an electronic protection apparatus of the circuit pattern 4) on the base board in the prior art uses an upward/downward component placement design, and in a component placement design, only whether module space meets a requirement is considered. Utilization of a copper layer on the back side of a pad is relatively low, and signals that need to be interconnected are connected by using a drill hole, and consequently, a module area is increased. When the component 3 is placed on the base board provided in this embodiment of the present invention, both a space constraint condition and an interconnection factor are considered, thereby improving overall module utilization and reducing a module area.

In specific setting, when multiple components 3 are applied to an embedded base board, pads of components 3 in a same direction to the circuit pattern 4 are of a same height, thereby ensuring a technological process of laser drilling. In addition, pad surfaces of components are used in the present invention to increase thin resin, reduce a drill hole depth and a drill hole up and down difference, and ensure a chip design of a small pad.

In addition, in a specific setting process, to improve security of the base board in use, the base board further includes a protective layer 5 that covers the thin resin layer 2. Multiple window structures 51 are disposed at the protective layer 5, and the multiple window structures 51 are in a one-to-one correspondence with external ports of the circuit pattern 4. The disposed protective layer 5 wraps the base board, thereby avoiding copper oxidation caused because of cable exposure of the circuit pattern 4 on the base board, and improving a use effect of the entire base board.

In the foregoing embodiment, a thickness of the thin resin layer 2 is from 20 µm to 30 µm in specific setting. Therefore, a puncturing depth and a pad footprint can be effectively controlled. The thickness of the thin resin layer 2 is 20 µm in more specific setting.

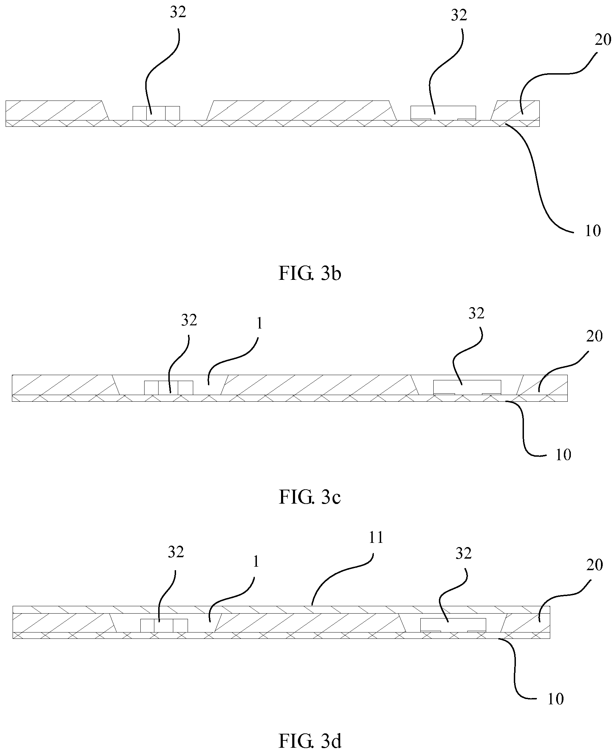

To understand the structure of the base board provided in this embodiment, with reference to FIG. 3a to FIG. 3m, the following describes in detail a production method of the based board provided in this embodiment. The method specifically includes:
placing a first component 32, where feet of first components 32 are located on a same plane;
performing filling with resin to wrap the first component 32, where the feet of the first components 32 are flush to a surface of the resin;
attaching a thin resin layer 2 to the surface of the resin; and
forming a circuit pattern 4 in the thin resin layer 2, where the circuit pattern 4 is connected to the first component 32.

In the foregoing embodiment in the foregoing technical solution, pad surfaces of components in a same direction (that is, feet of components 3) are located in a same plane, and thin resin is pressed, thereby meeting a same depth requirement of a component pad to a copper layer. Therefore, in a production process of the base board, the thin resin layer 2 is punctured to expose the feet of the components 3, and puncturing depths are the same, thereby implementing puncturing controllability. In addition, a requirement for a pad size and a pad spacing is reduced. This facilitates processing, improves a connection effect of the circuit pattern 4, and resolves problems of properness of an overall module layout and product miniaturization and thinness.

To help understand the foregoing method, the following describes steps of the method in detail with reference to specific accompanying drawings.

Step 1: As shown in FIG. 3a to FIG. 3c, place a mold 20 in a first adhesive film 10, where the mold 20 includes a hollow-out structure 201 that accommodates a first component 32; place the first component 32 in the hollow-out structure 201, where a foot of the first component 32 is attached to the first adhesive film 10; and fill the hollow-out structure 201 of the mold 20 with resin.

Specifically, one side of the first adhesive film 10 is adhesive, and the mold 20 is disposed on the adhesive side of the first adhesive film 10. The mold 20 includes multiple hollow-out structures 201, and the hollow-out structure 201 is used to accommodate the first component 32. The first component 32 is placed in the hollow-out structure 201. During placement, the foot of the first component 32 faces the first adhesive film 10, and the first component 32 is fastened by using adhesiveness of the first adhesive film 10. Then, the hollow-out structure 201 is filled with the resin, so that a surface layer of the resin is flush to a top surface of the hollow-out structure 201. In the foregoing method, a component 3 is placed by using the disposed mold 20. This facilitates embedment of the component 3, and improves production efficiency and a product qualification ratio.

Step 2: As shown in FIG. 3d to FIG. 3h, stick a second adhesive film 11 on one side that is of the mold 20 and that is opposite to the first adhesive film 10; detach the mold 20, and remove the first adhesive film 10; place a second component 31, and bond a foot of the second component 31 to the second adhesive film 11; and perform filling with resin to wrap the second component 31.

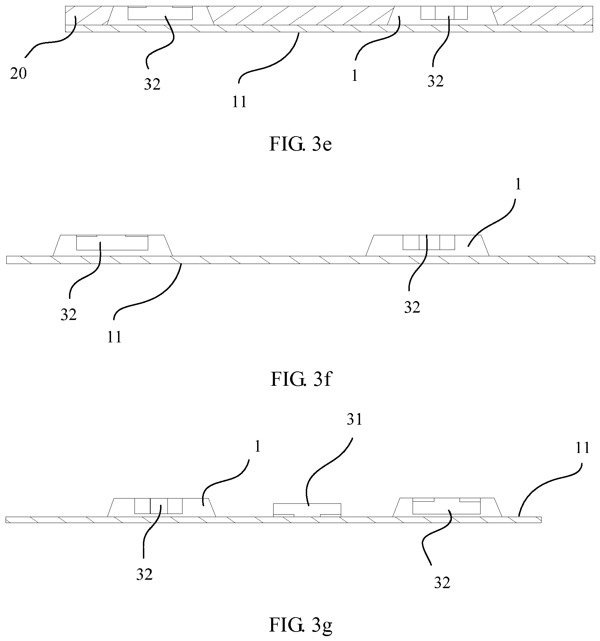

Specifically, as shown in FIG. 3d, the second adhesive film 11 is attached to one side that is of the mold 20 and that is opposite to the first adhesive film 10, that is, the resin for filling is stuck by using the second adhesive film 11. Then, as shown in FIG. 3e, the first adhesive film 19 is removed, and as shown in FIG. 3f, the mold 20 is removed. In this case, the resin for filling is stuck to the second adhesive film 11.

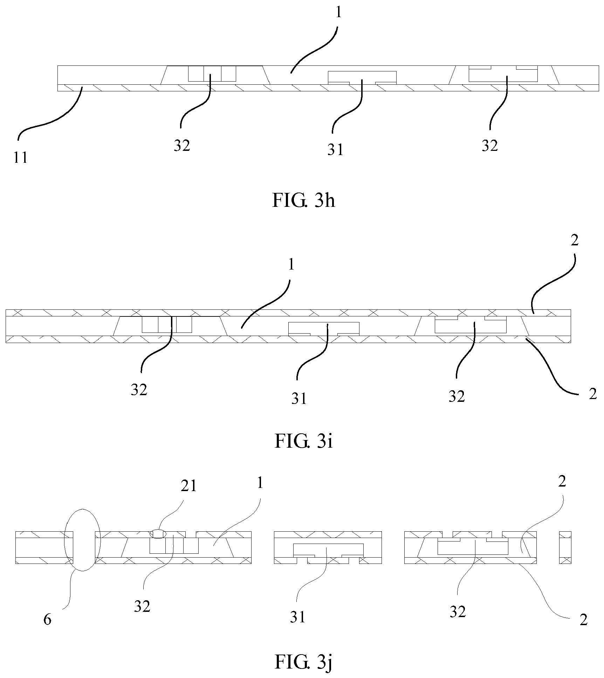

As shown in FIG. 3g, the second component 31 is placed in the second adhesive film 11. In this case, the foot of the second component 31 is stuck to the second adhesive film 11. Then, as shown in FIG. 3h, filling is performed with the resin to wrap the second component 31. The second component 31 is disposed on another side of a resin layer 1, thereby improving distribution efficiency of a circuit pattern 4. In addition, when the component 3 is being disposed, a foot of the component 3 faces a connection point that is of the circuit pattern 4 and that is correspondingly connected to the foot of the component 3, thereby simplifying a layout of the circuit pattern 4, shortening a cabling length, improving utilization of the base board, and further improving an overall effect of the base board.

Step 3: As shown in FIG. 3i to FIG. 3j, remove the second adhesive film 11, separately stick a thin resin layer 2 to two sides of a formed resin layer 1, disposing an opening in the thin resin layer 2 to expose the foot of the first component 32 and the foot of the second component 31; and disposing a through hole 21 in the resin layer 1 and the thin resin layer 2 according to a designed circuit pattern 4.

Specifically, as shown in FIG. 3i, the second adhesive film 11 is removed. In this case, both the first component 32 and the second component 31 are embedded in the resin layer 1, and the foot of the first component 32 and the foot of the second component 31 are exposed out of a surface of the resin layer 1. The surface is used to attach the thin resin layer 2. Continuing to refer to FIG. 3i, the thin resin layer 2 is stuck to two opposite surfaces of the resin layer 1. A thickness of the thin resin layer 2 is from 20 µm to 30 µm in specific setting. Therefore, a puncturing depth and a pad footprint can be effectively controlled. The thickness of the thin resin layer 2 is 20 µm in more specific setting. As shown in FIG. 3j, after two layers of thin resin layers 2 are stuck, the through hole 21 is disposed in the stuck thin resin layer 2. The through hole 21 is corresponding to the foot of the first component 32 and the foot of the second component 31. In addition, a penetrative through hole 21 is further disposed in the thin resin layer 2 and the resin layer 1, and the through hole 21 is used to form a plated through hole 6 and connect circuit patterns 4 located in the two thin resin layers 2 to form an entire circuit pattern 4.

Step 4: Copper the thin resin layer 2 to form a copper clad layer 41, and etch the copper clad layer 41 to form the circuit pattern 4, that is, separately copper two sides of the thin resin layer 2, and etch plated copper to form the circuit pattern 4.

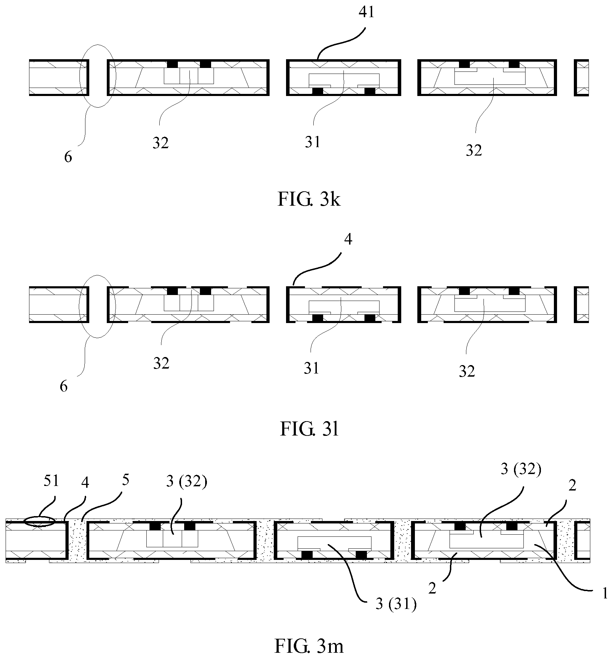

Specifically, as shown in FIG. 3k, the two thin resin layers 2 are separately covered with copper, and during the coppering, the copper clad layer 41 is connected to the foot of the first component 32 and the foot of the second component 31. In addition, the copper clad layer 41 penetrates through the through hole 21 that threads through the thin resin layer 2 and the resin layer 1 to form the plated through hole 6. As shown in FIG. 3l, the copper clad layer is etched to form the circuit pattern 4. In this case, an entire circuit pattern 4 is formed on the base board, and in the circuit pattern 4, both the foot of the first component 32 and the foot of the second component 31 face one side that is of the circuit pattern 4 and that is correspondingly connected to the foot of the first component 32 and the foot of the second component 31, thereby reducing setting of the circuit pattern 4, avoiding overuse of the plated through hole 6, and improving layout properness of the circuit pattern 4.

Step 5: As shown in FIG. 3m, coat a protective layer 5, and dispose, at the protective layer, a window structure 51 corresponding to an external port of the circuit pattern 4.

Specifically, as shown in FIG. 3m, the circuit pattern 4 is protected by using the disposed protective layer 5, thereby avoiding oxidation of the circuit pattern 4, and improving security of the entire base board in use. When the protective layer 5 is being coated, the protective layer 5 fills the plated through hole 6 to protect metal in the plated through hole 6, thereby improving security of the entire base board. The protective layer 5 may be a paint layer in specific setting.

The base board provided in the foregoing embodiment may be applied to different products, such as a communications device or an electrical device, for example, a mobile phone, a tablet, a wireless router, a wearable electronic device, a light fixture, an air conditioner, an electric water heater, an electricity meter, a video camera, a telephone set, and a computer.

In a specific embodiment, an embodiment of the present invention further provides a mobile terminal. The mobile terminal includes a housing, a power supply module disposed within the housing, and a control module connected to the power supply module, and the power supply module and the control module each include the above base board.

In the foregoing embodiment, the power supply module and the control module each use the base board in the foregoing embodiment. It should be understood that when the power supply module and the control module use the foregoing base board, a circuit pattern and an embedded component on the base board are selected according to functions of the power supply module and the control module. It can be learned from the foregoing embodiment that, all pad surfaces of components in a same direction on the base board are located in a same plane. This meets a same depth requirement of a component pad to a copper layer, reduces a requirement for a pad size and a pad spacing, and facilitates processing. Further, a connection effect of the circuit pattern is improved, and problems of properness of an overall module layout and product miniaturization and thinness are resolved. According to an effect of the foregoing base board, when the power supply module and the control module provided in this embodiment use the foregoing base board, processing efficiency of the power supply module and the control module and an electrical connection effect can be effectively improved, miniaturization and thinness development is promoted, and product miniaturization and thinness in electrical connection in which the power supply module, the control module, and the like use a structure of the foregoing base board is further improved. The base board improves effects of the control module and the power supply module, thereby improving production processing efficiency of the mobile terminal and an electrical connection effect, and further promoting miniaturization and thinness development of the mobile terminal.

In specific setting, the mobile terminal may be different terminals, such as a mobile phone or a wearable communications device.

Obviously, a person skilled in the art can make various modifications and variations to the present invention without departing from the spirit and scope of the present invention. The present invention is intended to cover these modifications and variations provided that they fall within the scope of protection defined by the following claims and their equivalent technologies.

## Claims

1. A base board, wherein the base board comprises an electrical pattern and multiple components, the base board further comprises a resin layer and a thin resin layer, the multiple components are embedded in the resin layer, and an end face that is of a foot of each component and that is used to connect the circuit pattern is exposed out of the resin layer and is flush to a surface of the resin layer; and the thin resin layer is attached to one exposed side of a foot of a component in the resin layer, a through hole corresponding to each foot is disposed in the thin resin layer, the circuit pattern is attached to one side that is of the thin resin layer and that is opposite to the resin layer, and the circuit pattern is connected to a pad that is electrically connected to a foot and that stretches into each through hole.

2. The base board according to claim 1, further comprising a protective layer that covers the thin resin layer, wherein multiple window structures are disposed at the protective layer, and the multiple window structures are in a one-to-one correspondence with external ports of the circuit pattern.

3. The base board according to claim 1, wherein feet of the multiple components are exposed to two opposite surfaces of the resin layer, the circuit pattern is distributed in two thin resin layers, two layers of the circuit pattern are connected by using a plated through hole that penetrates through the resin layer and the thin resin layer, and a foot of each component in the multiple components faces one side that is of the circuit pattern and that is connected to the foot of each component.

4. The base board according to claim 1, wherein a thickness of the thin resin layer is from 20 µm to 30 µm.

5. The base board according to claim 4, wherein the thickness of the thin resin layer is 20 µm.

6. A mobile terminal, comprising a housing, a power supply module disposed within the housing, and a control module connected to the power supply module, wherein the power supply module and the control module each comprise the base board according to any one of claims 1 to 5.

7. The mobile terminal according to claim 6, wherein the mobile terminal is a mobile phone or a wearable communications device.
